# EUROPÄISCHE PATENTANMELDUNG

(11) **EP 4 560 658 A2**
(43) Veröffentlichungstag der Anmeldung: **28.05.2025**
(21) Anmeldenummer: 25154735.2
(22) Anmeldetag: 16.11.2023
(51) Int. Cl.: H01F 27/38

(54) **SIGNALÜBERTRAGUNGSVORRICHTUNG FÜR ANALOGE STROMSIGNALE**

(62) Teilanmeldung aus: 23210372.1
(71) Anmelder: Pepperl+Fuchs SE, 68307 Mannheim (DE)
(72) Erfinder: Behrens, Ulrich, 69469 Weinheim (DE)
(74) Vertreter: Banse & Steglich Patentanwälte PartmbB

(57) **Zusammenfassung**

Die Erfindung betrifft eine Signalübertragungsschaltung (1) für ein analoges Stromsignal in einem explosionsgeschützten Bereich, umfassend:
- einen Transformator (2) mit einer oder mehreren primärseitigen Spulen (4, 4a, 4b) und einer oder mehreren sekundärseitigen Spulen (6, 6a, 6b), die über ein Transformatorjoch (J) in einem gemeinsamen magnetischen Kreis gekoppelt sind;
- eine Regelungsschaltung (10), die ausgebildet ist, um zur Flusskompensation die Spannung über die eine oder die mehreren sekundärseitigen Spulen (6, 6a, 6b) durch Bereitstellen eines Kompensationsstroms zu null zu regeln, wobei die Regelungsgröße einer Messspannung entspricht, die eines von:
o abhängig von einer Spannung über einer in dem magnetischen Kreis angeordneten Messspule (8) erhalten wird; und
o abhängig von einer Spannung über einer der mehreren sekundärseitigen Spulen (6a, 6b) in dem magnetischen Kreis erhalten wird, wenn diese unbestromt ist,

wobei das zu übertragende analoge Stromsignal dem Kompensationsstrom entspricht oder davon abhängt.

## Beschreibung

### Technisches Gebiet

Die Erfindung betrifft Signalübertragungsvorrichtungen für die Übertragung von analogen Stromsignalen einer Stromschleifenschnittstelle mit galvanischer Trennung.

### Technischer Hintergrund

In der Prozessautomatisierung werden üblicherweise analoge Signale über Stromschleifenschnittstellen übertragen, die abhängig von dem zu übertragenden analogen Signal einen Strom von 0 bzw. 4 bis 20 mA einstellen. Diese Form der analogen Signalübertragung basierend auf einem variablen Strom stellt einen sehr robusten Signalisierungsstandard dar und ist in vielen Bereichen der Prozessautomatisierung üblich.

In explosionsgeschützten Bereichen ist es jedoch notwendig, zwischen einem Sensormodul im Bereich der Messstelle und einem Steuergerät einer Leitwarte eine galvanische Trennung vorzusehen. Galvanische Trennungen werden im Bereich der Signalübertragung häufig durch Transformatoren realisiert.

Eine Übertragung des Stromsignals erfolgt mithilfe eines Transformators, dessen Primärseite und Sekundärseite Wicklungen identischer Anzahl von Windungen und entgegengesetztem Wicklungssinn aufweisen. Bei einem Wechselstromsignal führen die Primärseite und die Sekundärseite den gleichen Strom, wenn der magnetische Fluss im Kern gleich Null ist.

Um den Fluss im Kern auf null einzustellen, so dass sich sekundärseitig ein Stromverlauf ergibt, der dem Stromverlauf der Primärseite entspricht, wird die Spannung auf der Sekundärseite mithilfe eines Stellstroms auf 0 V geregelt. Der Stellstrom der Regelung entspricht dann dem primärseitigen Strom, d. h. dem Stromsignal.

Da das zu übertragende analoge Stromsignal ein Gleichstromsignal bzw. ein sehr niederfrequentes Signal sein kann, ist in der Regel vorgesehen, eine DC/AC-Wandlung auf der Primärseite und eine AC/DC-Wandlung auf der Sekundärseite des Transformators vorzusehen. In der Regel erfolgt die DC/AC-Wandlung durch periodisches Umpolen, d.h. das Anlegen des periodisch umgepolten Stromsignals an die primärseitige Spule des Transformators mithilfe eines primärseitigen Wechselrichters und ein entsprechendes Anlegen des Kompensationsstromes an der sekundärseitigen Spule mithilfe eines sekundärseitigen Wechselrichters. Die primärseitigen und sekundärseitigen Wechselrichter werden in der Regel gegenphasig betrieben.

Jedoch führt eine solche Anordnung dazu, dass die parasitären Eigenschaften der Halbleiterschalter der Wechselrichter und der parasitären ohmschen Widerstände der Kupferwicklungen der Spulen die Signalübertragung verfälschen.

Es ist damit wünschenswert, eine Kompensation der parasitären Einflüsse vorzunehmen. Die parasitären Einflüsse können in der Regel durch aufwendige Maßnahmen kompensiert werden, jedoch müssen die entsprechenden Kompensationen bei jeder Signalübertragungsschaltung separat vorgenommen werden, da die Effekte in der Regel nicht linear sind. Zudem sind die parasitären Einflüsse temperaturabhängig, so dass weiterhin eine Temperaturkompensation vorgesehen werden muss.

Es ist daher Aufgabe der vorliegenden Erfindung, eine verbesserte Signalübertragungsschaltung für ein Stromsignal einer Stromschleife mit einer galvanischen Trennung vorzusehen, bei der eine zusätzliche Kompensation der parasitären Einflüsse nicht notwendig ist.

### Offenbarung der Erfindung

Diese Aufgabe wird durch die Signalübertragungsschaltung nach Anspruch 1 gelöst.

Weitere Ausgestaltungen sind in den abhängigen Ansprüchen angegeben.

Gemäß einem ersten Aspekt ist eine Signalübertragungsschaltung für ein analoges Stromsignal in einem explosionsgeschützten Bereich vorgesehen, umfassend:
- einen Transformator mit einer oder mehreren (vorzugsweise zwei) primärseitigen Spulen und einer oder mehreren (vorzugsweise zwei) sekundärseitigen Spulen, die über ein Transformatorjoch in einem gemeinsamen magnetischen Kreis gekoppelt sind und insbesondere identische Windungszahlen aufweisen;
- eine Regelungsschaltung, die ausgebildet ist, um zur Flusskompensation die Spannung über die eine oder die mehreren sekundärseitigen Spulen durch Bereitstellen eines Kompensationsstroms zu null zu regeln, wobei die Regelungsgröße einer Messspannung entspricht, die
abhängig von einer Spannung über einer in dem magnetischen Kreis angeordneten Messspule erhalten wird; wobei das zu übertragende analoge Stromsignal dem Kompensationsstrom entspricht oder davon abhängt.

Weiterhin kann die Signalübertragungsschaltung eine Steuereinheit und einen ersten Wechselrichter umfassen, wobei der erste Wechselrichter durch die Steuereinheit angesteuert ist, um das analoge Stromsignal als zyklisches Wechselstromsignal an der primärseitigen Spule anzulegen, oder alternativ der erste Wechselrichter durch die Steuereinheit angesteuert ist, um das analoge Stromsignal wechselweise an jeweils eine der mehreren primärseitigen Spulen anzulegen.

Weiterhin kann in dem magnetischen Kreis die Messspule angeordnet sein und die Signalübertragungsschaltung weiterhin umfassen:
- einen zweiten Wechselrichter, der durch die Steuereinheit angesteuert ist, um den Kompensationsstrom zyklisch wechselweise oder zyklisch umgepolt an die eine oder die mehreren sekundärseitigen Spulen anzulegen,
wobei die Steuereinheit ausgebildet ist, den ersten Wechselrichter und den zweiten Wechselrichter zyklisch in Phase oder gegenphasig, insbesondere mit einer Schaltfrequenz zwischen 10kHz und 350kHz, zu betreiben.

Wie eingangs beschrieben, können Signalübertragungsschaltungen für Stromsignale in explosionsgeschützten Bereichen Wechselrichter aufweisen, bei der ein erster, primärseitiger Wechselrichter ein Stromsignal einer Stromschleife in ein Wechselstromsignal umwandelt und an die primärseitige Spule eines Transformators anlegt. Die sekundärseitige Spule ist mit einem zweiten, sekundärseitigen Wechselrichter verbunden, der gegenphasig zu dem ersten, primärseitigen Wechselrichter betrieben ist, so dass das angelegte Stromsignal gegenphasig zum primärseitig angelegten Stromsignal auf das Transformatorjoch wirkt.

Die Wechselrichter sind in der Regel als H-Brückenschaltungen für eine zyklische Umpolung der primärseitigen und/oder sekundärseitigen Spule oder als Zweiwegeschaltung für die wechselweise Bestromung jeweils einer der mehreren primärseitigen und/oder mehreren sekundärseitigen Spulen ausgelegt und werden durch ein geeignetes Steuergerät angesteuert. Die Wechselrichter dienen dazu, ein konstantes bzw. niederfrequentes Stromsignal in ein periodisches Wechselstromsignal umzuwandeln und dieses mithilfe des Transformators zu übertragen. Durch den Transformator wird eine galvanische Trennung gewährleistet.

Sind die Wechselrichter als Zweiwegeschaltung vorgesehen, können diese durch jeweils zwei alternierende Schalter (Halbleiterschalter) und zwei in Reihe geschalteten Spulen realisiert werden. Die Mittenknoten der Zweiwegeschaltung können Quelle oder Senke für den Signalstrom und / oder den Kompensationsstrom sein. Die Halbleiterschalter der Zweiwegeschaltung werden wechselweise geschaltet. Das wechselweise Schalten erfolgt so, dass die Durchflutungsrichtung im magnetischen Kreis bei jedem Schaltvorgang umgeschaltet wird.

Um das Stromsignal zu übertragen, wird in der Regel eine Flusskompensation vorgesehen, die kontinuierlich mithilfe einer Regelung gewährleistet, dass die Spannung über der sekundärseitigen Spule 0 Volt beträgt. Dann entspricht - die gleiche Windungsanzahl der Primärseite und der Sekundärseite vorausgesetzt - der primärseitige Strom durch die primärseitige Spule dem sekundärseitigen Strom der sekundärseitigen Spule.

Die Flusskompensation kann die sekundärseitige Spannung als Regelungsgröße verwenden, indem ein Kompensationsstrom eingeprägt wird, der kontinuierlich so geregelt wird, dass die sekundärseitige Spannung zu 0 Volt eingestellt wird. Dies führt jedoch zu Stromflüssen durch die Halbleiterschalter des zweiten sekundärseitigen Wechselrichters und der Sekundärspule, die von parasitären Einflüssen aufgrund von Spannungsabfällen über dem ohmschen Widerstand der Sekundärspule und über die Durchlasswiderstände der geschlossen geschalteten Halbleiterschalter des zweiten Wechselrichters beeinflusst sind. Diese werden herkömmlich durch die Regelungsschaltung ebenfalls ausgeglichen und führen zu einem Kompensationsstrom der von dem abzubildenden primärseitigen Stromsignal abweicht. Dadurch wird bisher die Stromspiegelung von der Primärseite zur Sekundärseite verfälscht, und eine Kompensation der parasitären Einflüsse auf das übertragene Stromsignal ist erforderlich. Zudem sind der Ohm`sche Widerstand der Sekundärspule und die Durchlasswiderstände der Halbleiterschalter stark temperaturabhängig, deren Kompensation ebenfalls aufwendig ist.

Weiterhin kann ein dritter Wechselrichter vorgesehen sein, um die Gleichrichtung der Spannung über der Messspule vorzunehmen.

Die obige Signalübertragungsschaltung zum Übertragen von Stromsignalen von Stromschleifen sieht daher in einer Variante zur Realisierung der Flusskompensation vor, den Transformator mit einer dritten Spule, einer Messspule, zu versehen, die über den dritten Wechselrichter mit der Regelungsschaltung verbunden ist, um die Messspannung als Regelungsgröße bereitzustellen.

Der dritte Wechselrichter kann synchron zu dem zweiten Wechselrichter angesteuert werden. Die Messspule ist induktiv ebenso wie die sekundärseitige Spule mit der primärseitigen Spule induktiv über das Transformatorjoch gekoppelt und liefert an ihren Anschlüssen somit eine Spannung bzw. einen Strom, die/der vom Fluss durch das Transformatorjoch abhängt.

Die Regelungsschaltung ist jedoch so ausgebildet, die sekundärseitige Spule so zu bestromen, dass der Fluss durch das Transformatorjoch zu null kompensiert wird. Die Regelungsschaltung basiert auf der mit dem dritten Wechselrichter gleichgerichteten Spannung der Messspule, die stromlos gemessen wird und somit parasitäre Effekte, die sich aufgrund ohmscher Widerstände auswirken, keinen Einfluss auf die Flusskompensation der Regelungsschaltung haben. Dadurch ist eine Kompensation der parasitären Einflüsse nicht notwendig, und eine Kalibrierung der Signalübertragungsschaltung kann gegebenenfalls entfallen. Auch der Temperatureinfluss ist kompensiert, da der Fluss durch die Messspule zu null geregelt wird.

Im Falle einer Zweiwegeschaltung zur Ansteuerung der mehreren sekundärseitigen Spulen in dem magnetischen Kreis gemäß einer weiteren Variante werden die sekundärseitigen Spulen wechselweise in den Strompfad durch die Regelungsschaltung geschaltet, wobei die jeweils andere unbestromt bleibt. Die jeweils unbestromte sekundärseitige Spule kann zum Bereitstellen der Messspannung verwendet werden.

Dazu kann die Regelungsschaltung einen Operationsverstärker aufweisen, der die Messspannung zu 0 Volt regelt, indem eine Spannungsabweichung der Messspannung von 0 Volt durch Bereitstellen eines variablen Kompensationsstroms durch den zweiten Wechselrichter und die sekundärseitige Spule ausgeregelt wird, wobei der Kompensationsstrom dem übertragenen Stromsignal entspricht.

Weiterhin kann die Regelungsschaltung einen Verstärkerhalbleiterschalter, insbesondere einen Bipolartransistor oder Feldeffekttransistor, aufweisen, der durch das Signal an einem Ausgang des Operationsverstärkers gesteuert wird, wobei der Verstärkerhalbleiterschalter die Höhe des Kompensationsstroms abhängig von dem Signal am Ausgang des Operationsverstärkers steuert.

Um höherfrequente Einschwingvorgänge nach dem Schalten der Wechselrichter zu filtern, kann ein Tiefpassfilter vorgesehen sein, der die Regelungsgröße glättet.

Weiterhin kann die Steuereinheit ausgelegt sein, um den dritten Wechselrichter mit einer Phasenverschiebung von zwischen 0 und 50 % der Periodendauer bezüglich des Betriebs des zweiten Wechselrichters zu betreiben.

Auch können die Schaltzeitpunkte für den dritten Wechselrichter der Messspule so bezüglich der Ansteuerung des zweiten Wechselrichters verzögert werden, dass zumindest ein Teil des Einschwingvorgangs nach dem Schalten der Halbleiterschalter des zweiten Wechselrichters ausgeblendet wird, wobei die Schaltverzögerung zwischen 0 % und 50 % der Periodendauer des zyklischen Betriebs der Wechselrichter beträgt.

Weiterhin kann die Energie in den Streuinduktivitäten einen erheblichen Einfluss auf die Übertragung des Stromsignals haben. Dies äußert sich in der Regel durch Einschwingvorgänge, die durch entsprechende Schaltungsmaßnahmen unschädlich gemacht werden. Solche Maßnahmen können Dämpfungsglieder wie z.B. R-C Kombinationen oder gezielte Ausblendung sein.

Weiterhin können die Wechselrichter jeweils durch eine H-Brückenschaltung realisiert werden, die durch jeweils zwei Inverterschaltungen realisiert sind. Die Mittenknoten der Inverterschaltungen sind über die jeweilige Spule miteinander verbunden. Die Halbleiterschalter werden wechselweise geschaltet. Das wechselweise Schalten erfolgt so, dass die Stromrichtung in den zwischen den Mittenknoten der seriell verschalteten Halbleiterschalter angeordneten Spulen bei jedem Schaltvorgang umgeschaltet wird.

Insbesondere kann der zyklische Betrieb der Wechselrichter ohne Schaltlücken oder mit einer Überlappung der Durchlassphasen der Halbleiterschalter mindestens einer der Inverterschaltungen vorgesehen ist.

In der Regel werden für das Schalten eines solchen Wechselrichters Schaltlücken vorgesehen, um eine Kurzschlussstromphase durch die Inverterschaltungen oder gleichzeitiges Einschalten der Schalter bei der Zweiwegeschaltung bei Auftreten von Schaltverzögerungen zu vermeiden. Diese Schaltlücken können dazu führen, dass der Kompensationsstrom über dem Stromwert des Stromsignals liegt. Da das Stromsignal jedoch kontinuierlich anliegt, wird die während der Schaltlücke eingebrachte Energie dem Mittelwert des Stromsignals hinzugefügt und muss damit mit einem entsprechenden Kompensationsstrom kompensiert werden. Um diesen Effekt zu vermeiden, kann vorgesehen sein, die Wechselrichter bzw. die Zweiwegeschaltung ohne Schaltlücke zu betreiben und gegebenenfalls ein Überlappen der Durchlassphasen (während die Halbleiterschalter geschlossen sind) der Halbleiterschalter z.B. für bis zu 5% der Periodendauer zu erlauben oder zuzulassen, in denen Halbleiterschalter eines Inverterzweiges der sekundärseitigen Spule kurzzeitig geschlossen sind, was keinen Einfluss auf die Übertragung des Stromsignals hat, da die Spannung über die sekundärseitige Spule ohnehin auf 0 Volt geregelt wird.

### Kurzbeschreibung der Zeichnungen

Ausführungsformen werden nachfolgend anhand der beigefügten Zeichnungen näher erläutert. Es zeigen:
- Figur 1: eine schematische Darstellung der Signalübertragungsschaltung gemäß einer Ausführungsform;
- Figur 2: eine schematische Darstellung einer Signalübertragungsschaltung gemäß einer weiteren Ausführungsform; und
- Figur 3: eine schematische Darstellung einer Signalübertragungsschaltung gemäß einem Beispiel.

Gleiche Bezugszeichen verweisen auf Elemente gleicher oder vergleichbarer Funktion.

### Beschreibung von Ausführungsformen

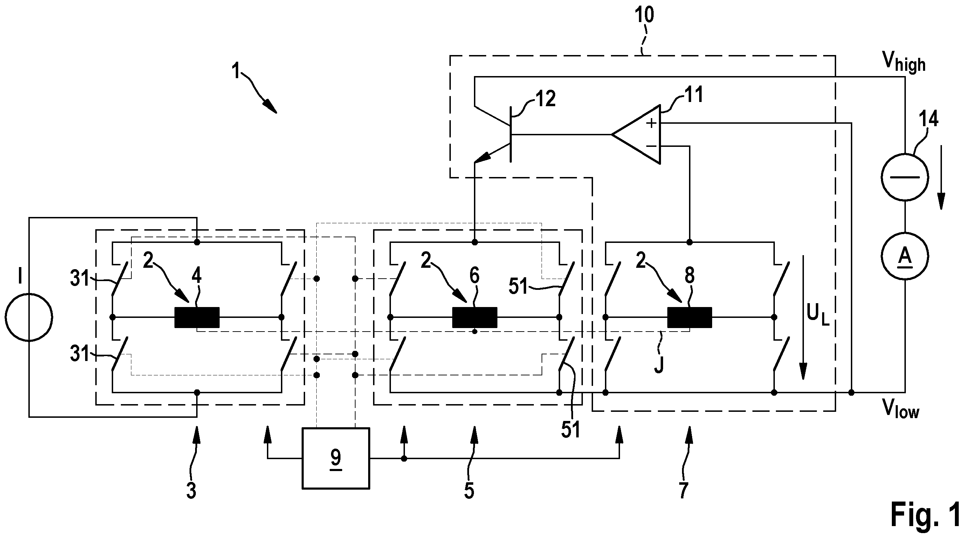

Figur 1 zeigt ein Schaltbild für eine Signalübertragungsschaltung 1 zur Übertragung eines Stromsignals. Das Stromsignal I kann ein in der Prozessautomatisierung übliches Stromsignal einer Stromschleife zwischen 0 bzw. 4 bis 20 mA sein. Das Stromsignal I entspricht einem analogen Signal, mit dem eine analoge Größe übertragen werden kann. Im explosionsgeschützten Bereich ist es notwendig, die Leitungen zur Übertragung des Stromsignals galvanisch von dem explosionsgeschützten Bereich zu trennen.

Die Signalübertragungsschaltung 1 sieht dazu vor, Stromsignale mithilfe eines Transformators 2 zu übertragen. Der Transformator 2 ist mit einer primärseitigen Spule 4 und einer sekundärseitigen Spule 6 ausgebildet, die über ein Transformatorjoch J miteinander in einem magnetischen Kreis gekoppelt sind. Die primärseitige Spule 4 und die sekundärseitige Spule 6 weisen vorzugsweise die gleiche Windungszahl auf und sind bezüglich ihrer Wicklungsrichtung entgegengesetzt.

Da das Stromsignal in der Regel kontinuierlich anliegt und sich nur niederfrequent ändert, ist ein erster Wechselrichter 3 für die primärseitige Spule 4 und ein zweiter Wechselrichter 5 für die sekundärseitige Spule 6 vorgesehen. Diese dienen dazu, das niederfrequente Stromsignal in ein Wechselstromsignal zu wandeln, um die Übertragung der Signalinformation über den Transformator 2 zu gewährleisten.

Die Wechselrichter 3, 5 sind als H-Brückenschaltungen ausgebildet und weisen zwei Inverterpfade aus seriell verschalteten Halbleiterschaltern 31, 51 auf, deren Mittelknoten M über die jeweilige Spule 4, 6 miteinander verbunden sind. Durch wechselweises Schalten der Halbleiterschalter 31, 51 kann die Polarität der Verschaltung der jeweiligen Spule 4, 6 periodisch umgekehrt werden, so dass eine entsprechende Signalübertragung über den Transformator 2 möglich ist.

Der erste Wechselrichter 3 und der zweite Wechselrichter 5 werden in der Regel in Phase oder gegenphasig betrieben, so dass der zweite Wechselrichter 5 das gleiche Stromsignal in den Transformator 2 einprägt wie der erste Wechselrichter 3. Die Ansteuerung der Halbleiterschalter 31, 51 erfolgt mit einer vorgegebenen Schaltfrequenz von zwischen 10kHz und 350kHz mithilfe einer Steuereinheit 9 oder dergleichen.

Es ist mithilfe einer Regelungsschaltung 10 vorgesehen, die Spannung über der sekundärseitigen Spule 8 zu regeln. Die Regelungsschaltung 10 weist dazu einen Operationsverstärker 11 auf und einen Verstärkerhalbleiterschalter 12, insbesondere einen Bipolartransistor oder Feldeffekttransistor, auf, der durch das Signal an einem Ausgang des Operationsverstärkers 11 gesteuert wird. Dazu steuert der Ausgang des Operationsverstärkers 11 steuert einen Steueranschluss (Basisanschluss oder Gate-Anschluss) des Verstärkerhalbleiterschalters 12 an.

Der Verstärkerhalbleiterschalter 12 ist zwischen einer Versorgungsspannungsquelle 14 und dem zweiten Wechselrichter 5 mit der sekundärseitigen Spule 6 geschaltet, so dass ein Strom durch den zweiten Wechselrichter 5 variabel eingestellt wird. Die Versorgungsspannungsquelle 14 stellt eine konstante Versorgungsspannung zwischen einem hohen Versorgungspotenzial V_{high} und einem niedrigen Versorgungspotenzial V_{low} bereit. Der Strom durch die Versorgungsspannungsquelle 14 stellt das übertragene Stromsignal dar.

Der nicht-invertierende Eingang des Operationsverstärkers 11 ist mit dem niedrigen Versorgungspotenzial V_{low}, das ein Referenzpotential oder ein Potenzial von 0 V angibt, verbunden. Der invertierende Eingang des Operationsverstärkers 11 ist mit einer flussabhängigen Messspannung verbunden.

Die Messspannung wird über eine dritte Spule, der Messspule 8, die in dem magnetischen Kreis des Transformators 2 angeordnet ist, erfasst. Der Messspule 8 ist ein dritter Wechselrichter 7 zugeordnet, um die in der Messspule 8 induzierte Spannung gleichzurichten und diese als Messspannung bereitzustellen. Dazu wird der dritte Wechselrichter 7 synchron zu dem zweiten Wechselrichter 5 angesteuert.

Der dritte Wechselrichter 7 ist zwischen dem niedrigen Versorgungspotenzial (Referenzpotenzial) und dem invertierenden Eingang des Operationsverstärkers 11 geschaltet.

Der Verstärkerhalbleiterschalter 12 ist zwischen einer Versorgungsspannungsquelle 14 und dem zweiten Wechselrichter 5 mit der sekundärseitigen Spule 6 geschaltet, so dass der Ausgang des Operationsverstärkers 11 den Stromfluss durch die sekundärseitige Spule 6 abhängig von einer Spannungsdifferenz über der Messspule 8 regelt. Tritt ein magnetischer Fluss im Transformatorjoch auf, so ändert sich die Messpannung, die der gleichgerichteten Spannung über der Messspule 8 entspricht, zu ungleich null, und es erfolgt ein Regelungseingriff über den Operationsverstärker 11 und den Verstärkerhalbleiterschalter 12 durch Einprägen eines Stroms auf die sekundärseitige Spule 6, so dass über der Messspule 8 die Spannung zu null geregelt wird. Der dafür erforderliche Strom entspricht im Wesentlichen dem Stromsignal der Primärseite des Transformators 2.

Um Effekte aus Einschwingvorgängen zu eliminieren, kann bezüglich der Ansteuerung des dritten Wechselrichters 7 das Ansteuersignal um bis zu 50 % bezüglich der Ansteuerung des zweiten Wechselrichters 5 verzögert werden.

Alternativ oder zusätzlich kann zwischen dem dritten Wechselrichter 7 und dem invertierenden Eingang des Operationsverstärkers ein Tiefpassfilter vorgesehen sein, der lediglich einen Gleichstromanteil der Messspannung an den Operationsverstärker 11 weitergibt.

Weiterhin können Streuinduktivitäten in geeigneter Weise eliminiert werden. Geeignete Mittel zu Neutralisierung der Streuinduktivitäten sind Dämpfungsglieder mit RC-Kombination oder Abtastverzögerung bei der Erfassung der Spannung über der Messspule 8.

In der Regel werden Wechselrichter, die in Form von H-Brückenschaltungen aufgebaut sind, mit Schaltlücken betrieben, um Kurzschlüsse über die Inverterpfade der Brückenschaltung zu vermeiden. Dies führt jedoch zu einer Erhöhung des Kompensationsstroms durch den Verstärkerhalbleiterschalter 12. Da eine Energieübertragung über den Transformator 2 mithilfe der Flusskompensation unterbunden wird, kann der Betrieb des zweiten Wechselrichters 5 und des dritten Wechselrichters 7 ohne Schaltlücken erfolgen, insbesondere kann eine Schaltüberlappung vorgesehen sein, die kurzzeitig einen Kurzschlusspfad über mindestens einen der Inverterpfade zulässt. Diese Überlappung kann zwischen 0 % und 5 % liegen. Da die Spannung über der sekundärseitigen Spule 6 und der Messspule 8 auf 0 V geregelt wird, kann der Kurzschluss in einem der Inverterpfade der Wechselrichter 5, 7 nicht zu einem signifikanten Stromfluss führen.

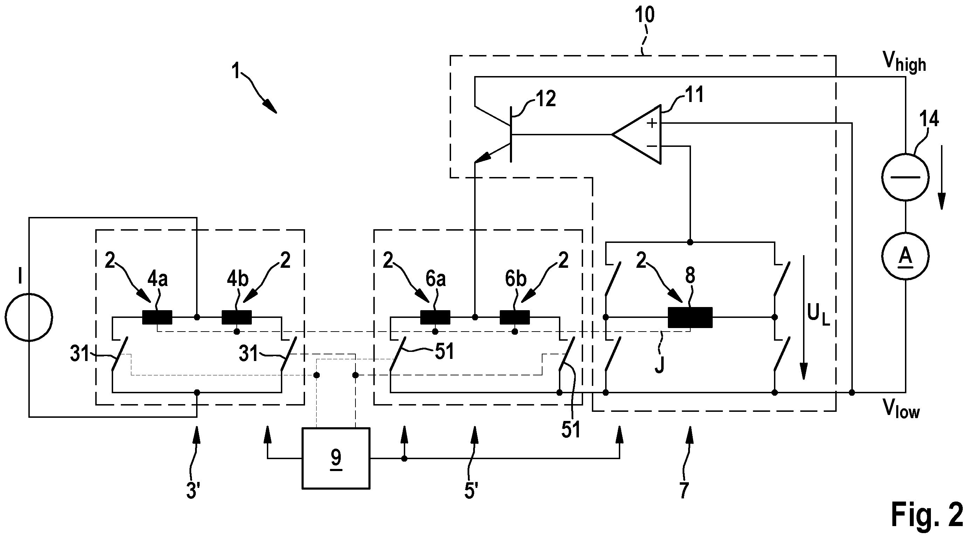

In Figur 2 ist eine weitere Ausführungsform der Signalübertragungsschaltung dargestellt. Im Unterschied zur Ausführungsform der Figur 1 sind die Wechselrichter 3', 5' nicht als H-Brückenschaltungen ausgebildet sondern als Zweiwegeschaltungen, die von der Steuereinheit 9 angesteuert werden, um jeweils eine von zwei primärseitigen Spulen 4a, 4b und eine von zwei sekundärseitigen Spulen 6a, 6b in den Strompfad zu schalten und die jeweils andere davon zu trennen. Die zwei primärseitigen Spulen 4a, 4b und die zwei sekundärseitigen Spulen 6a, 6b sind durch das Transformatorjoch im gleichen magnetischen Kreis angeordnet. Jeweils eine der Spulen ist seriell mit einem Halbleiterschalter verbunden und so von dem Strompfad trennbar.

Die Ansteuerung der Wechselrichter 3', 5' erfolgt mithilfe der Messspule 8 und dem dritten Wechselrichter 7 analog zur Ausführungsform der Figur 1. Es kann auch vorgesehen sein, einer der Wechselrichter als H-Brückenschaltung zur Ansteuerung nur einer Spule und den anderen der Wechselrichter als Zweiwegschaltung zur Ansteuerung von zwei Spulen auszubilden.

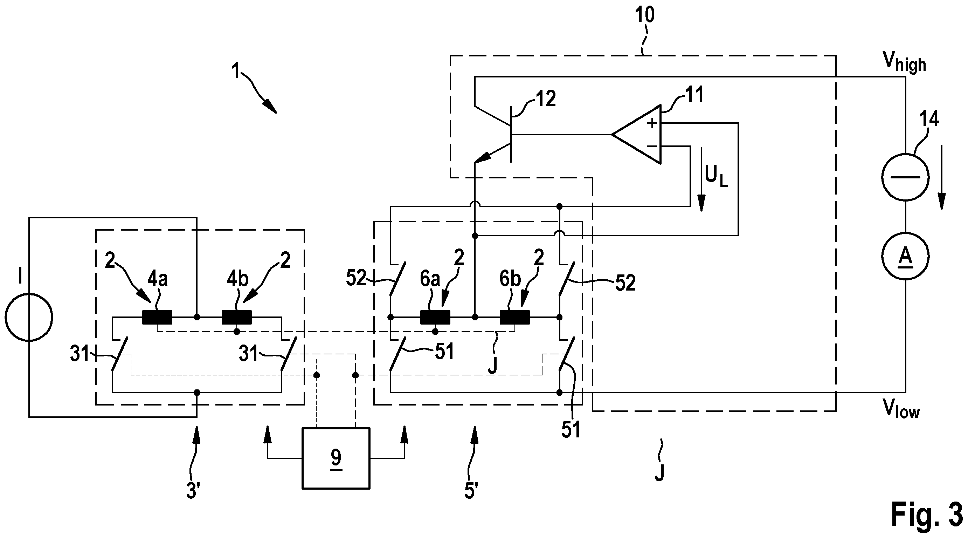

In Figur 3 ist ein Beispiel für die Signalübertragungsschaltung dargestellt. Wie in der Ausführungsform der Figur 2 ist der zweite Wechselrichter 5' als Zweiwegeschaltung ausgebildet, die von der Steuereinheit 9 angesteuert wird. Der erste Wechselrichter 3 kann als H-Brückenschaltung zur Ansteuerung nur einer primärseitigen Spule oder als Zweiwegschaltung zur Ansteuerung von zwei primärseitigen Spulen 4a, 4b ausgebildet sein.

Die Knoten zwischen den sekundärseitigen Spulen 6a, 6b und den jeweiligen Halbleiterschaltern des zweiten Wechselrichters 5' sind über weitere Halbleiterschalter 52 mit dem invertierenden Eingang des Operationsverstärkers 11 verbunden. Die Wechselrichter werden in oben beschriebener Weise von der Steuereinheit 9 angesteuert. Die weiteren Halbleiterschalter 52 werden von der Steuereinheit 9 angesteuert, um die jeweils nicht bestromte sekundärseitige Spule 6a, 6b mit dem Operationsverstärker zu verbinden und die jeweils andere davon zu trennen.

## Patentansprüche

1. Signalübertragungsschaltung (1) für ein analoges Stromsignal in einem explosionsgeschützten Bereich, umfassend:
- einen Transformator (2) mit einer oder mehreren primärseitigen Spulen (4, 4a, 4b) und einer oder mehreren sekundärseitigen Spulen (6, 6a, 6b), die über ein Transformatorjoch (J) in einem gemeinsamen magnetischen Kreis gekoppelt sind;
- eine Regelungsschaltung (10), die ausgebildet ist, um zur Flusskompensation die Spannung über die eine oder die mehreren sekundärseitigen Spulen (6, 6a, 6b) durch Bereitstellen eines Kompensationsstroms zu null zu regeln, wobei die Regelungsgröße einer Messspannung entspricht, die
abhängig von einer Spannung über einer in dem magnetischen Kreis angeordneten Messspule (8) erhalten wird;
wobei das zu übertragende analoge Stromsignal dem Kompensationsstrom entspricht oder davon abhängt.

2. Signalübertragungsschaltung (1) nach Anspruch 1, weiterhin umfassend:
- eine Steuereinheit (9),
- einen ersten Wechselrichter (3, 3'), der durch die Steuereinheit (9) angesteuert ist, um das analoge Stromsignal als zyklisches Wechselstromsignal an der einen oder den mehreren primärseitigen Spulen (4, 4a, 4b) anzulegen.

3. Signalübertragungsschaltung (1) nach Anspruch 1, weiterhin umfassend:
- eine Steuereinheit (9),
- einen ersten Wechselrichter (3, 3'), der durch die Steuereinheit (9) angesteuert ist, um das analoge Stromsignal wechselweise an jeweils eine der mehreren primärseitigen Spulen (4a, 4b) anzulegen.

4. Signalübertragungsschaltung (1) nach Anspruch 2 oder 3, wobei in dem magnetischen Kreis die Messspule (8) angeordnet ist und die Signalübertragungsschaltung (1) weiterhin umfasst:
- einen zweiten Wechselrichter (5, 5'), der durch die Steuereinheit (9) angesteuert ist, um den Kompensationsstrom zyklisch umgepolt oder zyklisch wechselweise an die eine bzw. die mehreren sekundärseitigen Spulen (6, 6a, 6b) anzulegen,
wobei die Steuereinheit (9) ausgebildet ist, den ersten Wechselrichter (3, 3') und den zweiten Wechselrichter (5, 5') zyklisch in Phase oder gegenphasig, insbesondere mit einer Schaltfrequenz zwischen 10kHz und 350kHz, zu betreiben.

5. Signalübertragungsschaltung (1) nach Anspruch 4, wobei ein dritter Wechselrichter (7) vorgesehen ist, um eine Gleichrichtung der Spannung über der Messspule (8) vorzunehmen.

6. Signalübertragungsschaltung (1) nach Anspruch 5, wobei die Steuereinheit (9) ausgelegt ist, um den dritten Wechselrichter (7) in Phase mit oder synchron zu dem zweiten Wechselrichter (5, 5') zu betreiben.

7. Signalübertragungsschaltung (1) nach Anspruch 5, wobei die Steuereinheit (9) ausgelegt ist, um den dritten Wechselrichter (7) mit einer Phasenverschiebung von zwischen 0 und 50 % der Periodendauer bezüglich des Betriebs des zweiten Wechselrichters (5, 5') zu betreiben.

8. Signalübertragungsschaltung (1) nach einem der Ansprüche 7, wobei die Schaltzeitpunkte für den dritten Wechselrichter (7) der Messspule (8) so bezüglich der Ansteuerung des zweiten Wechselrichters (5, 5') verzögert werden, dass zumindest ein Teil des Einschwingvorgangs nach dem Schalten der Halbleiterschalter (51) des zweiten Wechselrichters (5, 5') ausgeblendet wird, wobei die Schaltverzögerung zwischen 0 % und 50 % der Periodendauer des zyklischen Betriebs der Wechselrichter beträgt.

9. Signalübertragungsschaltung (1) nach einem der Ansprüche 1 bis 3, wobei mehrere sekundärseitige Spulen (6a, 6b) in dem magnetischen Kreis vorgesehen sind, die mithilfe eines zweiten Wechselrichters (5`) wechselweise in den Strompfad durch die Regelungsschaltung geschaltet werden, wobei die jeweils unbestromte sekundärseitige Spule (6a, 6b) zum Bereitstellen der Messspannung verwendet wird.

10. Signalübertragungsschaltung (1) nach einem der Ansprüche 1 bis 9, wobei die eine oder die mehreren primärseitigen Spulen (4, 4a, 4b) und die eine oder die mehreren sekundärseitigen Spulen (6, 6a, 6b), die gleichzeitig stromführend sind, identische Windungszahlen aufweisen.

11. Signalübertragungsschaltung (1) nach einem der Ansprüche 1 bis 10, wobei die Regelungsschaltung (10) einen Operationsverstärker (11) aufweist, der die Messspannung zu 0 Volt regelt, indem eine Spannungsabweichung der Messspannung von 0 Volt durch Bereitstellen eines variablen Kompensationsstroms durch den zweiten Wechselrichter (5, 5') und die sekundärseitige Spule (6, 6a, 6b) ausgeregelt wird, wobei der Kompensationsstrom dem übertragenen Stromsignal entspricht.

12. Signalübertragungsschaltung (1) nach Anspruch 11, wobei die Regelungsschaltung (10) einen Verstärkerhalbleiterschalter (12) , insbesondere einen Bipolartransistor oder Feldeffekttransistor, aufweist, der durch das Signal an einem Ausgang des Operationsverstärkers (11) gesteuert wird, wobei der Verstärkerhalbleiterschalter (12) die Höhe des Kompensationsstroms abhängig von dem Signal am Ausgang des Operationsverstärkers (11) steuert.

13. Signalübertragungsschaltung (1) nach einem der Ansprüche 1 bis 11, wobei die Wechselrichter (3, 5) als H-Brückenschaltungen mit Inverterschaltungen oder als Zweiwegeschaltung mit jeweils mindestens zwei Halbleiterschalter (31, 51) ausgelegt sind, wobei der zyklische Betrieb der Wechselrichter (3, 5) ohne Schaltlücken oder mit einer Überlappung der Durchlassphasen der Halbleiterschalter (3, 5) mindestens einer der Inverterschaltungen oder der Zweiwegeschaltung vorgesehen ist.

14. Signalübertragungsschaltung (1) nach einem der Ansprüche 1 bis 12, wobei die Messspannung tiefpassgefiltert wird.
